# EUROPEAN PATENT APPLICATION

(11) **EP 2 784 041 A1**
(43) Date of publication of application: **01.10.2014**
(21) Application number: 14155693.6
(22) Date of filing: 19.02.2014
(51) Int. Cl.: C04B 35/01, C04B 35/622, C23C 18/12

(54) **LaNiO3 thin film-forming composition and method of forming LaNiO3 thin film using the same**

(30) Priority: 25.03.2013 JP 2013061914
(71) Applicant: MITSUBISHI MATERIALS CORPORATION, Chiyoda-ku Tokyo (JP)
(72) Inventor: Fujll, Jun, Naka-shi, Ibaraki (JP); Sakurai, Hideaki, Naka-shi, Ibaraki (JP); Soyama, Nobuyuki, Naka-shi, Ibaraki (JP)
(74) Representative: Gille Hrabal

(57) **Abstract**

This LaNiO₃ thin film-forming composition includes: LaNiO₃ precursors; and acetic acid, wherein a ratio of an amount of the LaNiO₃ precursors to 100 mass% of an amount of the LaNiO₃ thin film-forming composition is in a range of 1 mass% to 20 mass% in terms of oxides, and the composition further includes a stabilizer containing N-methyl formamide in an amount of more than 0 mol to 10 mol or less per 1 mol of the total amount of the LaNiO₃ precursors in the composition.

## Description

### BACKGROUND OF THE INVENTION

### Field of the Invention

The present invention relates to a composition for forming a LaNiO₃ thin film, which is used for an electrode of a thin film capacitor, a ferroelectric random access memory (FeRAM) capacitor, a piezoelectric element, a pyroelectric infrared-detecting element, or the like, with a chemical solution deposition (CSD) method; and a method of forming a LaNiO₃ thin film using this composition. More specifically, the present invention relates to a composition for forming a LaNiO₃ thin film which is superior in electrical properties and is suitable for controlling the crystal orientation of a dielectric layer or the like formed on the film; and a method of forming a LaNiO₃ thin film using this composition.

The present application claims priority on Japanese Patent Application No. 2013-061914 filed on March 25, 2013, the content of which is incorporated herein by reference.

### Description of Related Art

LaNiO₃ (LNO) is known as a material having superior electrical properties such as high conductivity and being strongly self-oriented with the (100) plane (for example, refer to "Preparation and evaluation of LaNiO3 thin film electrode with chemical solution deposition", Journal of the European Ceramic Society 24 (2004), 1005 to 1008). Further, due to its pseudo-cubic perovskite structure, a LaNiO₃ (LNO) thin film has superior affinity with a perovskite type ferroelectric thin film and has a small misfit in a lattice constant. Therefore, the LaNiO₃ (LNO) thin film is used as a crystal orientation-controlling layer when a ferroelectric thin film which is preferentially oriented with the (100) plane is formed in a thin film capacitor or the like. In addition, the LaNiO₃ (LNO) thin film has a relatively small electric resistance, and as compared to a case where a metal such as Pt is used for an electrode, the LaNiO₃ (LNO) thin film has superior polarization reversal fatigue characteristics of a ferroelectric film. Therefore, the LaNiO₃ (LNO) thin film itself can also be used as an electrode film of a ferroelectric random access memory capacitor, a piezoelectric element, or the like. Further, due to its translucency, the LaNiO₃ (LNO) thin film can also be used as an electrode film of a pyroelectric infrared-detecting element or the like.

### SUMMARY OF THE INVENTION

### Problems to be Solved by the Invention

As a result of investigation, the present inventors found that, even when a LaNiO₃ (LNO) thin film is formed using a material, a method, and the like disclosed in well-known documents of the related art such as "Preparation and evaluation of LaNiO3 thin film electrode with chemical solution deposition", Journal of the European Ceramic Society 24 (2004), 1005 to 1008, the LaNiO₃ (LNO) thin film is not self-oriented or the self-oriented degree thereof varies depending on conditions such as the kind of precursor to be used, the combination of the precursor with other components such as solvent or the like, and the ratios of the components. Particularly, when a LaNiO₃ (LNO) thin film is formed with a chemical solution deposition (CSD) method such as a sol-gel method, specific conditions and the like for obtaining a considerably high self-orientation property of LaNiO₃ (LNO) have not been clearly disclosed in the documents of the related art yet.

An object of the invention is to provide a composition for forming a LaNiO₃ thin film having superior electrical properties and capable of being used as an electrode film of a ferroelectric random access memory capacitor, a piezoelectric element, a pyroelectric infrared-detecting element, or the like and allowing the crystal orientation of a dielectric layer, which is formed on the film in a thin film capacitor or the like, to be easily preferentially oriented with the (100) plane; and a method of forming a LaNiO₃ thin film using this composition.

### Means for Solving the Problems

According to a first aspect of the invention, a LaNiO₃ thin film-forming composition is provided, which includes: LaNiO₃ precursors; and acetic acid, wherein a ratio of an amount of the LaNiO₃ precursors to 100 mass% of an amount of the LaNiO₃ thin film-forming composition is in a range of 1 mass% to 20 mass% in terms of oxides, and the LaNiO₃ thin film-forming composition further includes a stabilizer containing N-methyl formamide in an amount of more than 0 mol to 10 mol or less per 1 mol of the total amount of the LaNiO₃ precursors in the LaNiO₃ thin film-forming composition.

According to a second aspect of the invention, in the LaNiO₃ thin film-forming composition according to the first aspect, each of the LaNiO₃ precursors may be a metal carboxylate, a metal nitrate, a metal alkoxide, a metal diol complex, a metal triol complex, a metal β-diketonate complex, a metal β-diketoester complex, a metal β-iminoketo complex, or a metal amino complex.

According to a third aspect of the invention, in the LaNiO₃ thin film-forming composition according to the second aspect, among the LaNiO₃ precursors, at least one of a LaNiO₃ precursor as a La source and a LaNiO₃ precursor as a Ni source may be an acetate or a nitrate.

According to a fourth aspect of the invention, a method of forming a LaNiO₃ thin film is provided, in which the LaNiO₃ thin film-forming composition according to any one of the first to third aspects is used.

According to a fifth aspect of the invention, a method of forming a LaNiO₃ thin film is provided, which includes: coating the LaNiO₃ thin film-forming composition according to any one of the first to third aspects on a heat-resistant substrate so as to form a coating film; and pre-baking the heat-resistant substrate including the coating film in an oxidation atmosphere or in a water vapor-containing atmosphere under atmospheric pressure, or repeating the forming of the coating film and the pre-baking of the heat-resistant substrate two or more times until a film having a predetermined thickness is obtained, and then baking the film at a crystallization temperature or higher, wherein a LaNiO₃ thin film is preferentially oriented with the (100) plane.

According to a sixth aspect of the invention, a method of manufacturing a complex electronic component is provided, in which the complex electronic component includes a LaNiO₃ thin film which is formed using the method according to the fourth or fifth aspect, and the complex electronic component is a thin film capacitor, a capacitor, an IPD, a DRAM memory capacitor, a laminated capacitor, a ferroelectric random access memory capacitor, a pyroelectric infrared-detecting element, a piezoelectric element, an electro-optic element, an actuator, a resonator, an ultrasonic motor, an electric switch, an optical switch, or an LC noise filter element.

### Effects of the Invention

The LaNiO₃ thin film-forming composition according to the first aspect includes: LaNiO₃ precursors; and acetic acid, wherein a ratio of an amount of the LaNiO₃ precursors to 100 mass% of an amount of the LaNiO₃ thin film-forming composition is in a range of 1 mass% to 20 mass% in terms of oxides, and the LaNiO₃ thin film-forming composition further includes a stabilizer containing N-methyl formamide in an amount of more than 0 mol to 10 mol or less per 1 mol of the total amount of the LaNiO₃ precursors in the LaNiO₃ thin film-forming composition. With the configuration according to the first aspect, when this LaNiO₃ thin film-forming composition is used, a LaNiO₃ thin film can be formed which has superior electrical properties such as conductivity, polarization reversal fatigue characteristics, and the like and which is capable of being used as an electrode film of a ferroelectric random access memory capacitor, a piezoelectric element, or the like. In addition, a LaNiO₃ thin film can be formed which is suitable for an electrode film of a pyroelectric infrared-detecting element or the like. In addition, when this LaNiO₃ thin film-forming composition is used, a LaNiO₃ thin film can be formed which is strongly preferentially oriented with the (100) plane. Therefore, particularly when a thin film capacitor, a piezoelectric element, or the like is manufactured, the film can also be used for forming a crystal orientation-controlling layer for controlling the crystal orientation of a dielectric layer. As a result, the crystal orientation of a dielectric film formed on the film can be easily preferentially oriented with the (100) plane.

In the LaNiO₃ thin film-forming composition according to the second aspect, a metal carboxylate, a metal nitrate, a metal alkoxide, a metal diol complex, a metal triol complex, a metal β-diketonate complex, a metal β-diketoester complex, a metal β-iminoketo complex, or a metal amino complex is included as each of the LaNiO₃ precursors. As a result, the uniformity of the composition can be further improved.

In the LaNiO₃ thin film-forming composition according to the third aspect, an acetate or a nitrate is included as at least one of a LaNiO₃ precursor as a La source and a LaNiO₃ precursor as a Ni source among the LaNiO₃ precursors. By using an acetate or a nitrate as the LaNiO₃ precursor, storage stability can be further improved even in the case where a LaNiO₃ thin film-forming composition having a relatively high concentration is prepared.

In the method of forming a LaNiO₃ thin film according to the fourth or fifth aspect, a LaNiO₃ thin film is formed using the above-described LaNiO₃ thin film-forming composition according to the present invention. In addition, the method of forming a LaNiO₃ thin film according to the fifth aspect includes: coating the above-described LaNiO₃ thin film-forming composition according to the invention on the heat-resistant substrate so as to form a coating film; and pre-baking the heat-resistant substrate including the coating film in an oxidation atmosphere or in a water vapor-containing atmosphere under atmospheric pressure, or repeating the forming of the coating film and the pre-baking of the heat-resistant substrate two or more times until a film having a predetermined thickness is obtained, and then baking the film at a crystallization temperature or higher. As a result, a LaNiO₃ thin film can be formed which has superior electrical properties and is strongly preferentially oriented with the (100) plane. With this method, a LaNiO₃ thin film can be formed which is strongly preferentially oriented with the (100) plane. Therefore, when the LaNiO₃ thin film obtained with this method is used as a crystal orientation-controlling layer, a dielectric layer which is preferentially oriented with the (100) plane can be relatively easily formed.

In the method according to the sixth aspect, for example, when a ferroelectric random access memory, a piezoelectric element, or the like is manufactured, a LaNiO₃ thin film obtained with the above-described method according to the invention is used as a capacitor electrode of the ferroelectric random access memory, an electrode of the piezoelectric element, or an electrode of the pyroelectric infrared-detecting element. As a result, a device having superior electrical properties, particularly, superior polarization reversal fatigue characteristics can be obtained. In addition, during the manufacture of a thin film capacitor or the like, when a LaNiO₃ thin film obtained with the above-described method according to the present invention is used as a crystal orientation-controlling layer for controlling the crystal orientation of a dielectric layer, the crystal orientation of the dielectric layer can be easily preferentially oriented with the (100) plane without conducting complicated film-forming conditions. In addition, particularly in the case of a piezoelectric element, piezoelectric characteristics can be improved.

### BRIEF DESCRIPTION OF THE DRAWING

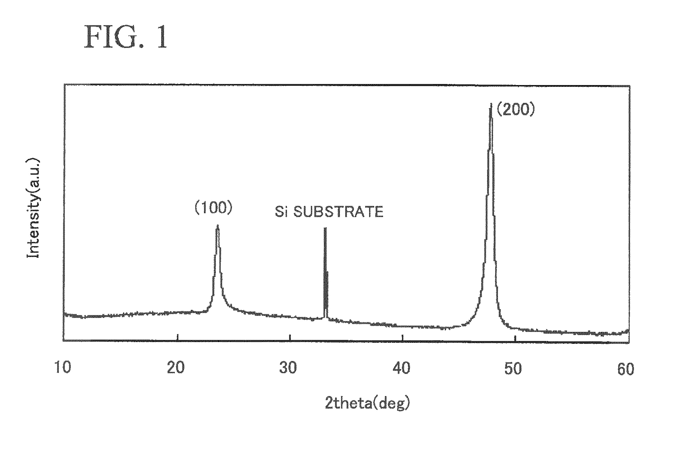

FIG 1 is a diagram illustrating an XRD pattern of a LaNiO₃ thin film formed in Example 1-1.

### DETAILED DESCRIPTION OF THE INVENTION

Next, embodiments of the invention will be described.

A LaNiO₃ thin film-forming composition (hereinafter, referred to as "composition") according to the present embodiment is an improvement of a composition for forming a LaNiO₃ thin film. As a characteristic of the composition according to the embodiment, the composition contains: LaNiO₃ precursors; and acetic acid, wherein a ratio of an amount of the LaNiO₃ precursors to 100 mass% of an amount of the composition is in a range of 1 mass% to 20 mass% in terms of oxides, and the composition further contains a stabilizer containing N-methyl formamide in an amount of more than 0 mol to 10 mol or less per 1 mol of the total amount of the LaNiO₃ precursors in the composition.

The LaNiO₃ precursors contained in the composition are raw materials for constituting a complex metal oxide (LaNiO₃) in the formed LaNiO₃ thin film. Examples of the LaNiO₃ precursors include metal carboxylates, metal nitrates, metal alkoxides, metal diol complexes, metal triol complexes, metal β-diketonate complexes, metal β-diketoester complexes, metal β-iminoketo complexes, and metal amino complexes which include metal elements La and Ni. Specifically, examples of a LaNiO₃ precursor as a La source include metal carboxylates such as lanthanum acetate, lanthanum 2-ethylhexanoate, and the like; metal nitrates such as lanthanum nitrate and the like; metal alkoxides such as lanthanum isopropoxide and the like; and metal β-diketonate complexes such as lanthanum acetylacetonate and the like. In addition, examples of a LaNiO₃ precursor as a Ni source include metal carboxylates such as nickel acetate, nickel 2-ethylhexanoate, and the like; metal nitrates such as nickel nitrate and the like; and metal β-diketonate complexes such as nickel acetylacetonate and the like. From the viewpoints of obtaining high solubility in a solvent, storage stability, and the like, it is preferable that at least one of the LaNiO₃ precursor as a La source and the LaNiO₃ precursor as a Ni source be an acetate or a nitrate. When the LaNiO₃ precursor as a La source and the LaNiO₃ precursor as a Ni source is a hydrate, the LaNiO₃ precursor as a La source and the LaNiO₃ precursor as a Ni source may be dehydrated in advance by heating or the like or may be dehydrated during the synthesis of the precursors by distillation or the like.

The reason for limiting the ratio of an amount of the LaNiO₃ precursors (both the La source and the Ni source) to 100 mass% of an amount of the composition to be in the above-described range in terms of oxides is as follows. When the amount ratio of the LaNiO₃ precursors is lower than the lower limit, the thickness of the coating film becomes excessively small, and there is a problem in that cracks may be formed on the film. On the other hand, when the amount ratio of the LaNiO₃ precursors is higher than the upper limit, storage stability may deteriorate, for example, precipitates may be formed. It is preferable that the amount ratio of the LaNiO₃ precursors contained in the 100 mass% of the composition be in a range of 3 mass% to 15 mass% in terms of oxides. The amount ratio of the LaNiO₃ precursors in terms of oxides refers to a ratio of an amount of metal oxides to 100 mass% of an amount of the composition on the assumption that all the metal elements contained in the composition are converted into oxides. In addition, it is preferable that a mixing ratio of the LaNiO₃ precursor as a La source and the LaNiO₃ precursor as a Ni source be adjusted such that a ratio (La/Ni) of La atoms to Ni atoms becomes 1:1.

The acetic acid contained in the composition is a solvent component of the composition. In the composition according to the embodiment, the reason for limiting the solvent component to acetic acid is that, when other solvents such as water are used as the solvent component, the coating film formability and the performance of a coating film formed using the obtained composition deteriorate. By using acetic acid as the solvent, a LaNiO₃ thin film which is strongly preferentially oriented with the (100) plane can be formed without deterioration in coating film formability and coating film performance.

The ratio of an amount of acetic acid to 100 mass% of an amount of the composition is preferably in a range of 2 mass% to 98 mass% and more preferably in a range of 40 mass% to 70 mass%. When the amount ratio of acetic acid is higher than the upper limit, the thickness of the coating film becomes excessively small, and there is a problem in that cracks may be formed on the film. When the ratio of acetic acid is lower than the lower limit, storage stability may deteriorate, for example, precipitates may be formed.

In addition, the composition further contains a stabilizer containing N-methyl formamide in an amount of more than 0 mol to 10 mol or less per 1 mol of the total amount of the LaNiO₃ precursors in the composition. Since the composition contains N-methyl formamide as the stabilizer, the coating film formability, the performance of a coating film formed using the obtained composition, and the storage stability of the composition can be improved. In addition, the reason why the amount of N-methyl formamide per 1 mol of the total amount of the LaNiO₃ precursors in the composition is limited to be in a range of 10 mol or less is as follows. When the amount is higher than 10 mol, the thermal decomposition of the stabilizer is delayed, and this causes a problem in that voids remain in the film. The amount of the stabilizer containing N-methyl formamide per 1 mol of the total amount of the LaNiO₃ precursors in the composition is more preferably in a range of 2 mol to 8 mol.

In order to obtain the LaNiO₃ thin film-forming composition according to the embodiment, first, the LaNiO₃ precursor as a La source and the LaNiO₃ precursor as a Ni source are prepared, respectively. These LaNiO₃ precursors are weighed such that the above-described desired metal atomic ratio is obtained. In addition, as the stabilizer, N-methyl formamide is prepared and weighed such that the above-described predetermined amount per 1 mol of the LaNiO₃ precursors (the total amount of the LaNiO₃ precursor as a La source and the LaNiO₃ precursor as a Ni source) is obtained.

Next, the LaNiO₃ precursors and N-methyl formamide as the stabilizer are poured into a reaction vessel, and acetic acid as the solvent is added thereto such that the ratio of an amount of the LaNiO₃ precursors to 100 mass% of an amount of the prepared composition becomes the above-described ratio. The above materials are sufficiently mixed until the solid contents are completely dissolved in the solvent to react with each other. As a result, a composition is obtained. After mixing, in order to suppress temporal changes of the composition, it is preferable that the composition be heated, preferably, in an inert gas atmosphere at a temperature of 80°C to 200°C for 0.5 hours to 2 hours.

In the embodiment, it is preferable that particles be removed from the composition prepared as above by filtration or the like such that the number of particles having particle sizes of 0.5 µm or greater (preferably 0.3 µm or greater and more preferably 0.2 µm or greater) becomes in a range of 50 particles or less per 1 mL of the solution. It is preferable that particles having particle sizes of 0.2 µm or greater in the composition be removed by filtration or the like. In order to measure the number of particles in the composition, a light-scattering particle counter is used.

When the number of particles having particle sizes of 0.5 µm or greater in the composition is more than 50 particles/mL, long-term storage stability deteriorates. The less the number of particles having particle sizes of 0.5 µm or greater in the composition is, the better the composition is. In particular, the number of particles is preferably less than or equal to 30 particles/mL.

A method of treating the prepared composition to obtain the above-described number of particles is not particularly limited. For example, the following methods may be used. A first method is a filtration method using a commercially available membrane filter having a pore size of 0.2 µm while supplying the composition with a syringe. A second method is a pressure filtration method in which a commercially available membrane filter having a pore size of 0.05 µm is combined with a pressure tank. A third method is a circulation filtration method in which the filter used in the second method is combined with a solution-circulating tank.

In all the methods, a particle capture rate by the filter varies depending on a solution supply pressure. It is generally known that, the lower the pressure is, the higher the capture rate is. Particularly in the first method and the second method, in order to realize the condition that the number of particles having a particle size of 0.5 µm or greater is in a range of 50 particles, it is preferable that the solution be made to pass extremely slowly through the filter at a low pressure.

Next, a method of forming a LaNiO₃ thin film according to the present embodiment will be described. First, the LaNiO₃ thin film-forming composition is coated on a substrate so as to form a coating film having a desired thickness. The coating method is not particularly limited, and examples thereof include spin coating, dip coating, liquid source misted chemical deposition (LSMCD), and electrostatic spray coating. A substrate on which the LaNiO₃ thin film is formed varies depending on the use of the film and the like. For example, when the LaNiO₃ thin film is used as a crystal orientation-controlling layer of a thin film capacitor or the like, a heat-resistant substrate, such as a silicon substrate or a sapphire substrate, on which a lower electrode is formed, is used. As the lower electrode which is formed on the substrate, a material, such as Pt, Ir, Ru, or the like is used which has conductivity and is not reactive with the LaNiO₃ thin film. In addition, for example, a substrate on which a lower electrode is formed with an adhesion layer, an insulating film, and the like interposed therebetween can be used. Specific examples of the substrate include substrates having a laminate structure (lower electrode/adhesion layer/insulating film/substrate) of Pt/Ti/SiO₂/Si, Pt/TiO₂/SiO₂/Si, Pt/IrO/Ir/SiO₂/Si, Pt/TiN/SiO₂/Si, Pt/Ta/SiO₂/Si, or Pt/Ir/SiO₂/Si. On the other hand, when the LaNiO₃ thin film is used as an electrode of a ferroelectric random access memory capacitor, a piezoelectric element, a pyroelectric infrared-detecting element, or the like, a heat-resistant substrate such as a silicon substrate, a SiO₂/Si substrate, or a sapphire substrate can be used.

After the coating film is formed on the substrate, this coating film is pre-baked and then baked to be crystallized. Pre-baking is performed using a hot plate, RTA, or the like under a predetermined condition. It is preferable that pre-baking be performed in the air, in an oxygen atmosphere or in a water vapor-containing atmosphere in order to remove a solvent and to thermally decompose or hydrolyze metal compounds to be converted into a complex oxide. Even during heating in the air, moisture required for hydrolysis is sufficiently secured with moisture in the air. Before pre-baking, particularly in order to remove low-boiling-point components or adsorbed water molecules, a low-temperature heat treatment may be performed using a hot plate at a temperature of 60°C to 120°C for 1 minute to 5 minutes. It is preferable that pre-baking be performed at a temperature of 150°C to 550°C for 1 minute to 10 minutes. In the case where a desired film thickness is obtained by performing the coating process once, the process from the coating of the composition to the pre-baking is performed once, and then baking is performed. Alternatively, the process from the coating of the composition to the pre-baking can be repeated multiple times until a film having a desired thickness is obtained, and, finally, baking can be performed in a batch process.

Baking is the process of baking the pre-baked coating film at a crystallization temperature or higher to be crystallized. As a result, a LaNiO₃ thin film is obtained. As a baking atmosphere, O₂, N₂, Ar, N₂O, H₂, or a mixed gas thereof is preferable. Baking is performed by holding the coating film preferably at a temperature of 450°C to 900°C for 1 minute to 60 minutes. Baking may be performed by rapid thermal annealing (RTA). A temperature increase rate from the room temperature to the baking temperature is preferably in a range of 10°C/sec to 100°C/sec.

Through the above-described processes, the LaNiO₃ thin film is obtained. The LaNiO₃ thin film formed as above has a low surface resistivity and superior conductivity and the like. Therefore, the LaNiO₃ thin film can be used as, for example, an electrode film of a ferroelectric random access memory capacitor, an electrode film of a piezoelectric element, or an electrode film of a pyroelectric infrared-detecting element. Further, since the LaNiO₃ thin film is strongly self-oriented with the (100) plane, the LaNiO₃ thin film can be suitably used as a crystal orientation-controlling layer for preferentially orienting the crystal orientation of a dielectric layer with the (100) plane in a thin film capacitor or the like. In addition, in the case of a piezoelectric element, piezoelectric characteristics can be improved.

### EXAMPLES

Next, examples of the present invention and comparative examples will be described in detail.

### <Example 1-1>

First, as the LaNiO₃ precursors, nickel acetate tetrahydrate (Ni source) and lanthanum nitrate hexahydrate (La source) were prepared, and these LaNiO₃ precursors were weighed such that an atomic ratio of La atoms to Ni atoms became 1:1. In addition, as the stabilizer, N-methyl formamide was prepared in an amount of 5 mol per 1 mol of the precursors. Next, the precursors, N-methyl formamide, and acetic acid as the solvent were poured into a reaction vessel such that the concentration of the precursors in the prepared composition became 4 mass% in terms of oxides, and then the mixture was stirred until the solid contents were completely dissolved in the solvent. As a result, a composition was prepared. After the preparation, the composition was filtered using a pressure filtration method in which a membrane filter and a pressure tank were combined.

Next, the obtained composition was dripped on a SiO₂/Si substrate which was set on a spin coater and had a crystal plane oriented with the (100) direction, and then spin-coating was conducted at a rotating speed of 2000 rpm for 20 seconds. As a result, a coating film was formed on the substrate. Next, before pre-baking and baking, the substrate on which the coating film was formed was held in the air at a temperature of 75°C for 1 minute using a hot plate. As a result, low-boiling-point components and adsorbed water molecules were removed. Next, the coating film formed on the substrate was pre-baked using a hot plate by being heated from room temperature to 400°C and held at this temperature for 5 minutes. Next, using RTA, in an oxygen atmosphere, the pre-baked coating film was baked by being heated to 800°C at a temperature increase rate of 10°C/sec and being held at this temperature for 5 minutes. As a result, a LaNiO₃ thin film was formed on the substrate. The film having a desired total thickness was formed by performing the process from the forming of the coating film to the pre-baking once without repetition and then performing the baking process once.

### <Example 1-2>

A composition was prepared in the same manner as Example 1-1, except that a film having a desired total thickness was formed by repeating the process from the forming of the coating film to the pre-baking 5 times and then performing the baking process once. Using this composition, a LaNiO₃ thin film was formed.

### <Example 1-3>

First, as the LaNiO₃ precursors, nickel acetate tetrahydrate (Ni source) and lanthanum nitrate hexahydrate (La source) were prepared, and these LaNiO₃ precursors were weighed such that an atomic ratio of La atoms to Ni atoms became 1:1. In addition, as the stabilizer, N-methyl formamide was prepared in an amount of 5 mol per 1 mol of the precursors. Next, the precursors, N-methyl formamide, and acetic acid as the solvent were poured into a reaction vessel such that the concentration of the precursors in the prepared composition became 4 mass% in terms of oxides, and then the mixture was stirred until the solid contents were completely dissolved in the solvent. The mixture was heated at a temperature of 140°C for 30 minutes; and thereby, a composition was obtained. After the preparation, the composition was filtered using a pressure filtration method in which a membrane filter and a pressure tank were combined.

Next, the obtained composition was dripped on a SiO₂/Si substrate which was set on a spin coater and had a crystal plane oriented with the (100) direction, and then spin-coating was conducted at a rotating speed of 2000 rpm for 20 seconds. As a result, a coating film was formed on the substrate. Next, before pre-baking and baking, the substrate on which the coating film was formed was held in the air at a temperature of 75°C for 1 minute using a hot plate. As a result, low-boiling-point components and adsorbed water molecules were removed. Next, the coating film formed on the substrate was pre-baked using a hot plate by being held at a temperature of 400°C for 5 minutes. Next, using RTA, in an oxygen atmosphere, the pre-baked coating film was baked by being heated to 800°C at a temperature increase rate of 10°C/sec and being held at this temperature for 5 minutes. As a result, a LaNiO₃ thin film was formed on the substrate. As is the case with Example 1, the film having a desired total thickness was formed by performing the process from the forming of the coating film to the pre-baking once without repetition and then performing the baking process once.

### <Examples 1-4 and 1-5 and Comparative Examples 1-1 and 1-2>

Compositions were prepared in the same manner as Example 1-1, except that the concentrations of the precursors in the compositions in terms of oxides were changed by adjusting the amount ratio of each component to the value shown in Table 1 below. Using these compositions, LaNiO₃ thin films were formed.

### <Examples 2-1 and 2-2 and Comparative Examples 2-1 and 2-2>

Compositions were prepared in the same manner as Example 1-1, except that the amounts of N-methyl formamide as the stabilizer per 1 mol of the precursors were adjusted to the values shown in Table 1 below. Using these compositions, LaNiO₃ thin films were formed. In Comparative Example 2-1, the amount ofN-methyl formamide per 1 mol of the precursors was 0 mol, that is, the composition was prepared without adding the stabilizer.

### <Example 3>

A composition was prepared in the same manner as Example 1-1, except that, as shown in Table 1 below, lanthanum isopropoxide (La source) and nickel acetylacetonate (Ni source) were used as the LaNiO₃ precursors instead of an acetate and a nitrate; and after stirring, the composition was heated under the same conditions as those of Example 1-3. Using this composition, a LaNiO₃ thin film was formed.

### <Comparison Test and Evaluation>

The thickness, the surface resistance value, and the preferentially oriented plane of each of the LaNiO₃ films obtained in Examples 1-1 to 3 and Comparative Examples 1-1 to 2-2 were evaluated. The results are shown in Table 1 below.

(1) Thickness: the thickness of a cross-section of the formed LaNiO₃ thin film was measured by imaging a cross-sectional image thereof using a scanning electron microscope (SEM, Hitachi S-4300SE).

(2) Surface resistance value: the surface resistance value of the LaNiO₃ thin film was measured using Loresta HP MCP-T410 (manufactured by Mitsubishi Chemical Corporation) according to a four-point probe method.

(3) Preferentially oriented plane: with a concentration method using an X-ray diffractometer (Model name: Empyrean, manufactured by PANalytical), the X-Ray diffraction (XRD) analysis of the LaNiO₃ thin film was performed. An orientation plane having the highest intensity among the obtained diffraction pattern in a 2θ range of 20° to 40° was set as a preferentially oriented plane. FIG. 1 is a representative diagram illustrating an XRD pattern of the thin film of Example 1-1 observed at this time.

**Table 1**

| | Composition | | | | | | Number of Coating Processes | Evaluation of Film | | |
|---|---|---|---|---|---|---|---|---|---|---|
| | Precursors | | | Stabilizer | | Solvent | | Thickness (nm) | Surface Resistivity (Ω/sq.) | Preferentially Oriented Plane |
| | La Source | Ni Source | Concentration (mass%) | Kind | Ratio (mol) | | | | | |
| Comparative Example 1-1 | Nitrate | Acetate | 0.5 | N-Methyl Formamide | 5 | Acetic Acid | 1 | - | - | - |
| Example 1-4 | Nitrate | Acetate | 1 | | 5 | Acetic Acid | 1 | 10 | 1050 | (100) |
| Example 1-1 | Nitrate | Acetate | 4 | | 5 | Acetic Acid | 1 | 45 | 230 | (100) |
| Example 1-3 | Nitrate | Acetate | 4 | | 5 | Acetic Acid | 1 | 40 | 300 | (100) |
| Example 1-2 | Nitrate | Acetate | 4 | | 5 | Acetic Acid | 5 | 210 | 3 | (100) |
| Example 1-5 | Nitrate | Acetate | 20 | | 5 | Acetic Acid | 1 | 150 | 10 | (100) |
| Comparative Example 1-2 | Nitrate | Acetate | 25 | | 5 | Acetic Acid | 1 | - | - | - |
| Comparative Example 2-1 | Nitrate | Acetate | 4 | - | 0 | Acetic Acid | 1 | - | - | - |
| Example 2-1 | Nitrate | Acetate | 4 | N-Methyl Formamide | 1 | Acetic Acid | 1 | 40 | 250 | (100) |
| Example 2-2 | Nitrate | Acetate | 4 | | 10 | Acetic Acid | 1 | 45 | 250 | (100) |
| Comparative Example 2-2 | Nitrate | Acetate | 4 | | 12 | Acetic Acid | 1 | - | - | - |
| Example 3 | Isopropoxide | Acetylacetonate | 4 | | 5 | Acetic Acid | 1 | 45 | 270 | (100) |

As can be clearly seen from Table 1, when Examples 1-1 to 1-5 were compared to Comparative Examples 1-1 and 1-2, the results were as follows. In Comparative Example 1-1 in which the concentration of the precursors in terms of oxides in 100 mass% of the composition was lower than 1 mass%, cracks were observed in the formed LaNiO₃ thin film to the extent that the cracks were able to be observed by visual inspection, and the film was not able to be uniformly formed. Therefore, the film was not able to be evaluated. In addition, in Comparative Example 1-2 in which the concentration of the precursors was higher than 20 mass%, precipitates were formed in the composition, and thus the LaNiO₃ thin film was not able to be formed. On the other hand, in Examples 1-1 to 1-5 in which the concentration of the precursors was in a range of 1 mass% to 20 mass%, LaNiO₃ thin films which had a low surface resistivity and were preferentially oriented with the (100) plane were able to be obtained without cracks, voids, and the like being formed.

In addition, when Examples 2-1 and 2-2 were compared to Comparative Examples 2-1 and 2-2, the results were as follows. In Comparative Example 2-1 in which N-methyl formamide, was not added as the stabilizer, cracks were observed in the formed LaNiO₃ thin film to the extent that the cracks were able to be observed by visual inspection, and the film was not able to be uniformly formed. Therefore, the film was not able to be evaluated. In addition, in Comparative Example 2-2 in which the amount ofN-methyl formamide per 1 mol of the total amount of the LaNiO₃ precursors in the composition is higher than 10 mol, voids were observed in the formed LaNiO₃ thin film to the extent that the voids were able to be observed by visual inspection, and the film was not able to be uniformly formed. Therefore, the film was not able to be evaluated. On the other hand, in Examples 2-1 and 2-2 in which the amounts of N-methyl formamide per 1 mol of the total amount of the LaNiO₃ precursors in the composition were in a range of 10 mol or less, LaNiO₃ thin films which had a low surface resistivity and were preferentially oriented with the (100) plane were able to be obtained without cracks, voids, and the like being formed. In addition, in Example 3 in which lanthanum isopropoxide and nickel acetylacetonate were used as the LaNiO₃ precursors, as is the case with Examples 1-1 to 2-2, a LaNiO₃ thin film which had a low surface resistivity and was preferentially oriented with the (100) plane was able to be obtained.

While preferred embodiments of the invention have been described and illustrated above, it should be understood that these are exemplary of the invention and are not to be considered as limiting. Additions, omissions, substitutions, and other modifications can be made without departing from the features of the present invention. Accordingly, the invention is not to be considered as being limited by the foregoing description, and is only limited by the scope of the appended claims. b

### Industrial Applicability

The present invention can be used for manufacturing a composite electronic component such as a thin film capacitor, a capacitor, an IPD, a DRAM memory capacitor, a laminated capacitor, a ferroelectric random access memory capacitor, a pyroelectric infrared-detecting element, a piezoelectric element, an electro-optic element, an actuator, a resonator, an ultrasonic motor, an electric switch, an optical switch, or an LC noise filter element.

## Claims

1. A LaNiO₃ thin film-forming composition comprising:
LaNiO₃ precursors; and
acetic acid,
wherein a ratio of an amount of the LaNiO₃ precursors to 100 mass% of an amount of the LaNiO₃ thin film-forming composition is in a range of 1 mass% to 20 mass% in terms of oxides, and
the LaNiO₃ thin film-forming composition further comprises a stabilizer containing N-methyl formamide in an amount of more than 0 mol to 10 mol or less per 1 mol of the total amount of the LaNiO₃ precursors in the LaNiO₃ thin film-forming composition.

2. The LaNiO₃ thin film-forming composition according to Claim 1,
wherein each of the LaNiO₃ precursors is a metal carboxylate, a metal nitrate, a metal alkoxide, a metal diol complex, a metal triol complex, a metal β-diketonate complex, a metal β-diketoester complex, a metal β-iminoketo complex, or a metal amino complex.

3. The LaNiO₃ thin film-forming composition according to Claim 2,
wherein among the LaNiO₃ precursors, at least one of a LaNiO₃ precursor as a La source and a LaNiO₃ precursor as a Ni source is an acetate or a nitrate.

4. A method of forming a LaNiO₃ thin film,
wherein the LaNiO₃ thin film-forming composition according to any one of Claims 1 to 3 is used.

5. A method of forming a LaNiO₃ thin film, comprising:
coating the LaNiO₃ thin film-forming composition according to any one of Claims 1 to 3 on a heat-resistant substrate so as to form a coating film; and
pre-baking the heat-resistant substrate including the coating film in an oxidation atmosphere or in a water vapor-containing atmosphere under atmospheric pressure, or repeating the forming of the coating film and the pre-baking of the heat-resistant substrate two or more times until a film having a predetermined thickness is obtained, and then baking the film at a crystallization temperature or higher,
wherein a LaNiO₃ thin film is preferentially oriented with a (100) plane.

6. A method of manufacturing a complex electronic component,
wherein the complex electronic component includes a LaNiO₃ thin film which is formed using the method according to Claim 4 or 5, and
the complex electronic component is a thin film capacitor, a capacitor, an IPD, a DRAM memory capacitor, a laminated capacitor, a ferroelectric random access memory capacitor, a pyroelectric infrared-detecting element, a piezoelectric element, an electro-optic element, an actuator, a resonator, an ultrasonic motor, an electric switch, an optical switch, or an LC noise filter element.
